# FASCICULE DE BREVET EUROPEEN

(11) **EP 1 158 656 B1**
(45) Date de publication et mention de la délivrance du brevet: **23.06.2010**
(21) Numéro de dépôt: 01401084.7
(22) Date de dépôt: 26.04.2001
(51) Int. Cl.: H02M 7/00

(54) **Dispositif électronique de puissance**
Elektronische Leistungsvorrichtung
Electronic power device

(30) Priorité: 22.05.2000 FR 0006512
(43) Date de publication de la demande: 28.11.2001
(73) Titulaire: ALSTOM Transport SA, 92300 Levallois-Perret (FR)
(72) Inventeur: Cettour-Rose, Jacques, 65200 Ordizan (FR); Fellmann, Daniel, 65420 Ibos (FR); Petitbon, Alain, 64000 Pau (FR)

(56) Documents cités:
- EP-A- 0 844 812
- FR-A- 2 775 416
- US-A- 5 574 312
- PATENT ABSTRACTS OF JAPAN vol. 0093, no. 28 (E-369), 24 décembre 1985 (1985-12-24) & JP 60 160151 A (FUJITSU LTD.), 21 août 1985 (1985-08-21)

## Description

L'invention se rapporte à un dispositif électronique de puissance et plus particulièrement à un dispositif comportant des puces de puissances fixées sur des plaques support, ces dernières étant refroidies par un fluide caloporteur. Le dispositif électronique de puissance selon l'invention s'applique notamment aux dispositifs électroniques utilisés dans les circuits de distribution d'énergie du domaine ferroviaire, de type convertisseur, pour lesquels les valeurs de courant et de tension délivrés sont particulièrement importantes.

De manière habituelle, il est connu de refroidir un composant électronique de puissance en l'accouplant à un échangeur de chaleur et en insérant entre ces deux éléments une plaque en céramique isolant électriquement l'échangeur du composant. Ainsi, le document FR 2 775 416 divulgue un dispositif électronique de puissance comportant des puces de puissance fixées sur une face d'une plaque support, l'autre face de la plaque comportant un échangeur de chaleur. Il est également connu de ce document d'associer les plaques support par paire en les disposant de part et d'autre d'un circuit de refroidissement, les échangeurs de chaleur étant alors disposés en vis-à-vis.

Un tel dispositif électronique de puissance présente toutefois l'inconvénient de générer des boucles de commutation à fortes inductances parasites et donc de fortes tension aux commutations, ce qui oblige à surdimensionner les composants de puissance afin qu'ils résistent à ces surtensions. Bien entendu, un tel surdimensionnement des composants de puissance présente l'inconvénient d'entraîner un surcoût de fabrication et un encombrement plus important des composants de puissance.

Le but de la présente invention est de proposer un dispositif électronique de puissance qui permette de pallier les inconvénients de l'art antérieur évoqués ci-dessus.

A cet effet, l'invention a pour objet un dispositif électronique de puissance comportant des plaques support présentant une face recevant un ou plusieurs composants de puissance et une face opposée au contact d'un fluide caloporteur pour le refroidissement par conduction des composants de puissance, caractérisé en ce qu'à au moins une plaque support est associée une autre plaque support disposée en vis-à-vis et munie de composants de puissance similaires, et en ce que les composants de puissance des deux plaques support en vis-à-vis sont disposés face à face et à proximité immédiate les uns des autres.

Selon des modes particuliers de réalisation, le dispositif électronique de puissance peut comprendre l'une ou plusieurs des caractéristiques suivantes prises isolément ou selon toutes les combinaisons techniquement possibles :
- à chaque plaque support est associée une autre plaque support disposée en vis-à-vis et munie de composants de puissance similaires, les composants de puissance des plaques support en vis-à-vis étant disposés face à face et à proximité immédiate les uns des autres ;
- les plaques support sont réparties sur deux cadres réalisés en matériau électriquement isolant, chacun des cadres comportant des ouvertures dont le pourtour forme un siège de réception des plaques support, les deux cadres présentant une forme permettant leur association l'un contre l'autre avec les plaques support des deux cadres en vis-à-vis, les deux cadres accolés supportant sur leur face libre un boîtier de refroidissement comprenant un volume de circulation du fluide caloporteur et des moyens d'amenée et d'évacuation du fluide caloporteur ;
- les deux cadres sont identiques ;
- chaque plaque support est alimentée en courant par au moins un émetteur et un collecteur débordant respectivement sur deux bords opposés de la plaque support de façon à ce que l'émetteur alimentant une plaque support soit disposé sur le même bord et à proximité du collecteur alimentant la plaque support disposée en vis-à-vis ;
- les cadres supportent les émetteurs, les collecteurs et un circuit de commande des composants de puissance ;
- les plaques support reçoivent chacune deux composants IGBT présentant un émetteur commun disposé entre les deux composants IGBT et sortant latéralement sur un côté du cadre, les composants IGBT comportant chacun un collecteur indépendant sortant latéralement sur l'autre côté du cadre ;
- une bande en matériau conducteur de chaleur, tel que du cuivre ou de l'aluminium, est brasée ou soudée sur la face des plaques support au contact du fluide caloporteur, la bande comportant des pliures constituant des micro-canaux favorisant l'échange thermique avec le fluide ;
- les cadres et les boîtiers sont réalisés par moulage en matériau plastique et sont assemblés les uns sur les autres par collage ou à l'aide d'un joint d'étanchéité.
- les plaques support sont réalisées par l'assemblage d'un matériau électriquement isolant mais conducteur de chaleur, tel que du nitrure d'aluminium, et d'un matériau composite conducteur de la chaleur ayant un coefficient de dilatation accordé à celui du matériau électriquement isolant, tel qu'un composite d'aluminium et de carbure de silicium, ledit matériau électriquement isolant supportant les composants de puissance et ledit composite étant au contact du fluide caloporteur.

On comprendra mieux les buts, aspects et avantages de la présente invention, d'après la description donnée ci-après d'un mode de réalisation de l'invention, présenté à titre d'exemple non limitatif, en se référant aux dessins annexés, dans lesquels :
- La figure 1 est une vue éclatée, en perspective, d'un mode de réalisation du dispositif électronique de puissance selon l'invention ;
- La figure 2 est une vue en perspective montrant l'assemblage des plaques support sur l'un des cadres du dispositif de la figure 1 ;
- La figure 3 est une vue agrandie, en perspective, du dispositif de la figure 1 lorsque les deux cadres et le boîtier inférieur sont assemblés ;
- La figure 4 est une vue similaire à la figure 3 lorsque tous les éléments sont assemblés.

Pour faciliter la lecture du dessin, seuls les éléments nécessaires à la compréhension de l'invention ont été représentés.

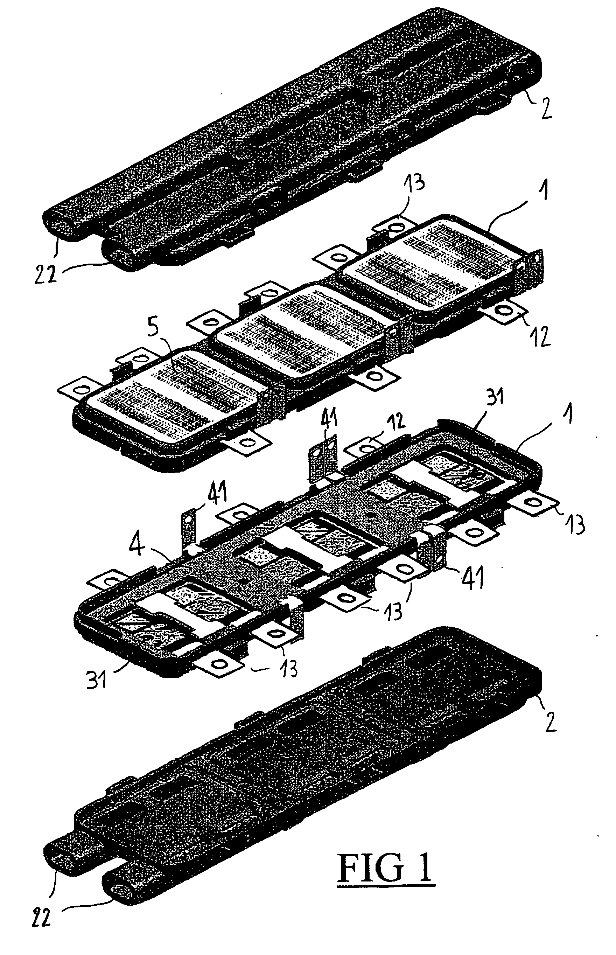

La figure 1 représente un dispositif électronique de puissance pour convertisseur comportant deux cadres 1 de forme générale rectangulaire pouvant s'accoler l'un contre l'autre par une de leur face et recevoir un boîtier de refroidissement 2 par l'autre face. Les cadres 1 sont sensiblement identiques et sont réalisés en un matériau moulable électriquement isolant, par exemple en résine moulable par injection, de type oxyde de polyphénylène (PPO).

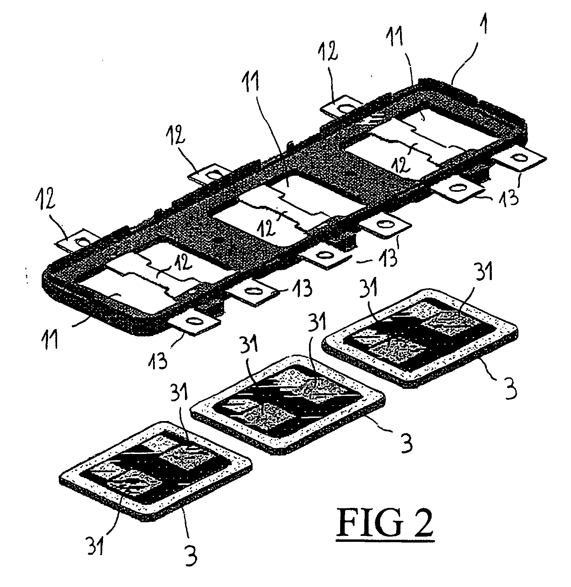

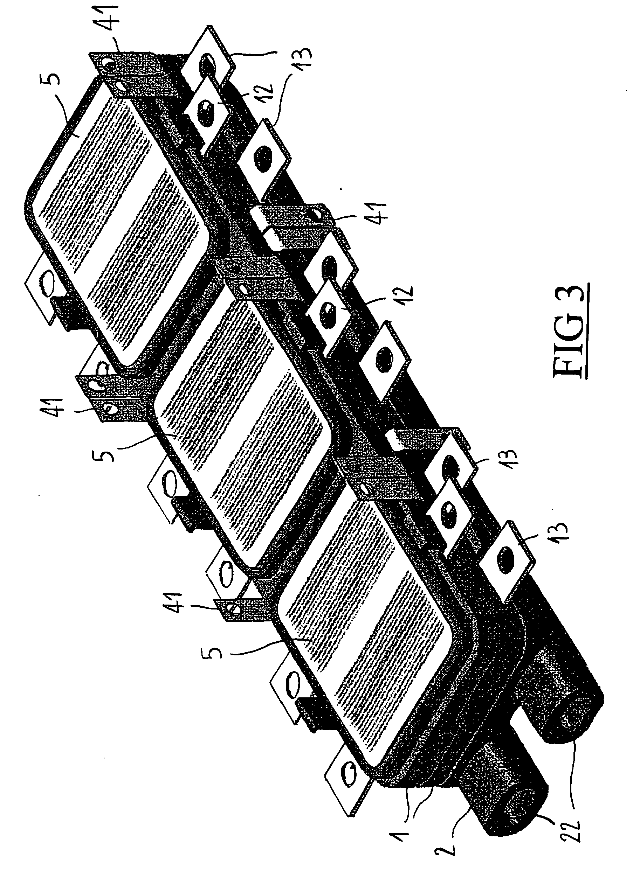

Conformément à la figure 2, chaque cadre 1 comporte trois ouvertures 11 recevant chacune une plaque support 3 en nitrure d'aluminium métallisé sur laquelle sont brasés deux composants de puissance 31 de type transistor bipolaire à grille isolé dit IGBT. Les plaques support 3 comportent également une bande de cuivre 5 brasée sur la face opposée à la face recevant les composants IGBT 31, ces bandes de cuivre 5 comportant des pliures constituant des microcanaux visibles sur les figures 1 et 3.

Les plaques support 3 sont maintenues en appui sur la périphérie intérieure des ouvertures 11 par collage avec éventuellement interposition d'un joint d'étanchéité, non représenté sur les figures, afin d'assurer la parfaite étanchéité de la liaison. Dans une variante de réalisation non représentée, l'étanchéité entre les plaques support 3 et le cadre 1 peut être également assurée par une coopération plus intime entre la plaque support 3 et le pourtour de l'ouverture 11 qui la reçoit, par exemple en surmoulant le cadre 1 sur les plaques support 3.

L'alimentation en courant de puissance des composants IGBT 31 de chaque plaque support 3 est effectuée au moyen d'émetteurs 12 et de collecteurs 13 intégrés au cadre 1 et sortant respectivement sur deux bords opposés du cadre 1. Les émetteurs 12 sont constitués, au niveau de chaque ouverture 11, d'un organe conducteur traversant de manière centrale l'ouverture 11 et servant d'émetteur commun aux deux composants IGBT 31 portés par la plaque support 3. Les émetteurs 12 comportent, à une extrémité, une languette de connexion sortant latéralement sur un côté du cadre 1 et permettant le raccordement à un connecteur extérieur, non représenté. Les collecteurs 13 sont constitués, au niveau de chaque ouverture 11, de deux organes conducteurs placés sur le bord de l'ouverture 11 opposé à celui recevant la languette de connexion de l'émetteur 12. Les collecteurs 13 sont disposés de part et d'autre de l'extrémité de l'émetteur 12 et se prolongent à l'extérieur du cadre 1 par une languette de connexion.

L'alimentation en courant de commande des composants IGBT 31 est effectuée au moyen d'un circuit imprimé 4 rapporté sur le cadre 1 et assurant la connexion des grilles des composants IGBT. Le circuit imprimé 4, représenté sur la figure 1, comporte des connecteurs 41 disposés perpendiculairement au plan du cadre 1 et permettant le raccordement avec des fils, non représentés, assurant la commande des composants IGBT.

Les deux cadres 1 présentent des formes complémentaires permettant leur assemblage l'un contre l'autre de telle sorte que les plaques support 3 des cadres 1 soient disposées en vis-à-vis et que les composants IGBT 31 portés par chaque plaque support 3 d'un cadre 1 soient disposés en regard et à proximité immédiate de composants IGBT 31 identiques portés par une plaque support 3 de l'autre cadre 1. Conformément à la figure 3, les deux cadres 1 une fois accolés forment un ensemble compact dans lequel seuls les microcanaux des bandes de cuivre 5 brasées sur les plaques support 3 ressortent de chaque ouverture 11.

Les microcanaux des plaques support 3 sont alimentés en fluide caloporteur par les deux boîtiers 2 qui sont rapportés sur les cadres 1, les boîtiers 2 comportant une face latérale plane munie d'un bord venant épouser le pourtour du cadre 1, un joint d'étanchéité, non représenté, étant interposé entre le boîtier 2 et le cadre 1.

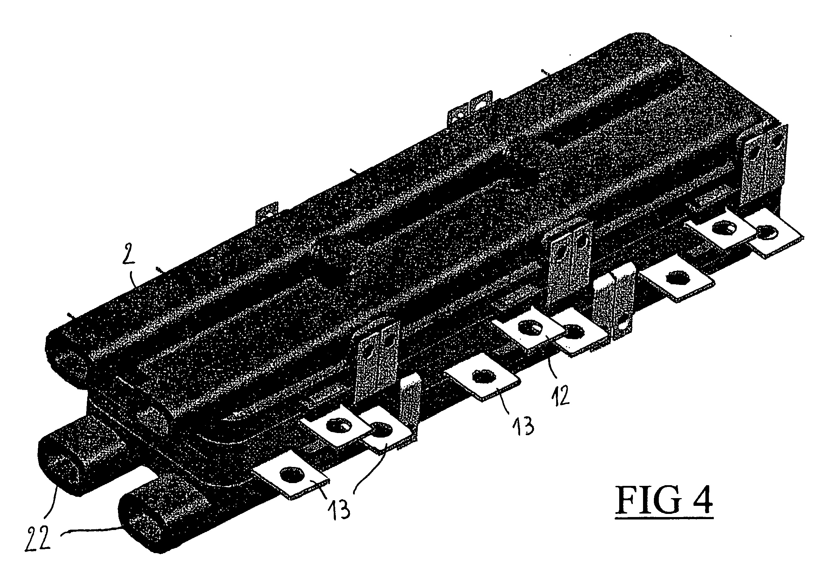

Conformément aux figures 1 et 4, les deux boîtiers 2 possèdent une forme globalement allongée et intègrent deux canaux s'étendant longitudinalement au cadre 1 et comportant une extrémité munie d'une ouverture 22 permettant l'alimentation et l'évacuation en fluide caloporteur. Avantageusement, les boîtiers 2 sont réalisés par moulage dans un matériau polymère, par exemple de type polyetherimide (PEI).

Un tel dispositif électronique de puissance présente l'avantage d'avoir de très faible inductances parasites grâce au rapprochement des composants de puissance portées par chaque plaque support avec des composants de puissance identiques portées par une plaque support disposée en vis-à-vis, ce qui permet de réduire considérablement les surtensions aux commutations. Un tel dispositif permet donc, pour une même puissance d'utilisation, l'utilisation de composants résistant à des surtensions moins importante et donc moins chers et également de tirer pleinement partie des possibilités d'amélioration du refroidissement.

Le dispositif selon l'invention présente également l'avantage de disposer les émetteurs des composants de puissance portés par une plaque support à proximité des collecteurs des composants de puissance portés par la plaque support disposée en vis-à-vis, ce qui permet d'annuler sensiblement les inductances parasites générées par ces derniers.

Par ailleurs, la réalisation d'un échangeur de chaleur à l'aide d'une bande de cuivre comportant des pliures formant des microcanaux et rapportée par brasage sur une plaque céramique de type standard permet d'assurer un excellent refroidissement des composants de puissance pour un très faible coût de fabrication.

Bien entendu, l'invention n'est nullement limitée au mode de réalisation décrit et illustré qui n'a été donné qu'à titre d'exemple.

Ainsi, dans une variante de réalisation du dispositif électronique selon l'invention, la bande de cuivre comportant des pliures pourra être réalisée dans un autre matériau conducteur de chaleur tel que l'aluminium.

Ainsi, dans une variante de réalisation, les plaques support pourront être réalisées en matériau composite constitué d'une couche métallique au contact du fluide caloporteur et d'une fine couche isolante supportant les composants de puissance.

## Revendications

1. Dispositif électronique de puissance comportant des plaques support (3) présentant une face recevant un ou plusieurs composants de puissance (31) et une face opposée au contact d'un fluide caloporteur pour le refroidissement par conduction desdits composants de puissance (31), **caractérisé en ce qu'**à au moins une plaque support (3) est associée une autre plaque support (3) disposée en vis-à-vis et munie de composants de puissance (31) similaires, et **en ce que** les composants de puissance (31) des deux plaques support (3) en vis-à-vis sont disposés face à face et à proximité immédiate les uns dés autres.

2. Dispositif électronique de puissance selon la revendication 1, **caractérisé en ce qu'**à chaque plaque support (3) est associée une autre plaque support (3) disposée en vis-à-vis et munie de composants de puissance (31) similaires, les composants de puissance (31) des plaques support (3) en vis-à-vis étant disposés face à face et à proximité immédiate les uns des autres.

3. Dispositif électronique de puissance selon l'une quelconque des revendication 1 à 2, **caractérisé en ce que** lesdites plaques support (3) sont réparties sur deux cadres (1) réalisés en matériau électriquement isolant, chacun des cadres (1) comportant des ouvertures (11) dont le pourtour forme un siège de réception desdites plaques support (3), lesdits deux cadres (1) présentant une forme permettant l'association des deux cadres (1) l'un contre l'autre avec les plaques support (3) des deux cadres (1) en vis-à-vis, les deux cadres (1) accolés supportant sur leur face libre un boîtier de refroidissement (2) comprenant un volume de circulation du fluide caloporteur et des moyens (22) d'amenée et d'évacuation dudit fluide.

4. Dispositif électronique de puissance selon la revendication 3, **caractérisé en ce que** lesdits deux cadres (1) sont identiques.

5. Dispositif électronique de puissance selon l'une quelconque des revendications 1 à 4, **caractérisé en ce que** chaque plaque support (3) est alimentée en courant par au moins un émetteur (12) et un collecteur (13) débordant respectivement sur deux bords opposés de la plaque support (3) de façon à ce que l'émetteur (12) alimentant une plaque support (3) soit disposé sur le même bord et à proximité du collecteur (13) alimentant la plaque support (3) disposée en vis-à-vis.

6. Dispositif électronique de puissance selon les revendications 3 et 5, **caractérisé en ce que** lesdits cadres (1) supportent lesdits émetteurs (12), lesdits collecteurs (13) et un circuit de commande (4) des composants de puissance (31).

7. Dispositif électronique de puissance selon l'une quelconque des revendications 5 à 6, **caractérisé en ce que** lesdites plaques support (3) reçoivent chacune deux composants IGBT (31) présentant un émetteur (12) commun disposé entre les deux composants IGBT (31) et sortant latéralement sur un côté du cadre (1), lesdits composants IGBT (31) comportant chacun un collecteur (13) indépendant sortant latéralement sur l'autre côté du cadre (1).

8. Dispositif électronique de puissance selon l'une quelconque des revendications 1 à 7, **caractérisé en ce qu'**une bande (5) en matériau conducteur de chaleur, tel que du cuivre ou de l'aluminium, est brasée ou soudée sur la face des plaques support (3) au contact du fluide caloporteur, ladite bande (5) comportant des pliures constituant des micro-canaux favorisant l'échange thermique avec ledit fluide.

9. Dispositif électronique de puissance selon l'une quelconque des revendications 1 à 8, **caractérisé en ce que** lesdits cadres (1) et boîtiers (2) sont réalisés, par moulage en matériau plastique et sont assemblés les uns sur les autres par collage ou à l'aide d'un joint d'étanchéité.

10. Dispositif électronique de puissance selon l'une quelconque des revendications 1 à 9, **caractérisé en ce que** lesdites plaques support (3) sont réalisées par l'assemblage d'un matériau électriquement isolant mais conducteur de chaleur, tel que du nitrure d'aluminium, et d'un matériau composite conducteur de la chaleur ayant un coefficient de dilatation accordé à celui du matériau électriquement isolant, tel qu'un composite d'aluminium et de carbure de silicium, ledit matériau électriquement isolant supportant les composants de puissance et ledit composite étant au contact du fluide caloporteur.

## Claims

1. Electronic power device comprising support plates (3) having a face receiving one or more power components (31) and an opposite face in contact with a coolant for cooling said power components (31) by conduction, **characterized in that** at least one support plate (3) is associated with another support plate (3) arranged facing it and provided with similar power components (31), and **in that** the power components (31) of the two facing support plates (3) are arranged face to face and in immediate proximity to one another.

2. Electronic power device according to Claim 1, **characterized in that** each support plate (3) has an associated other support plate (3) arranged facing it and provided with similar power components (31), the power components (31) of the facing support plates (3) being arranged face to face and in immediate proximity to one another.

3. Electronic power device according to either of Claims 1 or 2, **characterized in that** said support plates (3) are distributed on two frames (1) made of an electrically-insulating material, each of the frames (1) comprising openings (11), the outline of which forms a seat for receiving said support plates (3), said two frames (1) having a shape making it possible to join the two frames (1) one against the other with the support plates (3) of the two frames (1) facing it, the two attached frames (1) supporting on their free face a cooling module (2) comprising a volume for circulating the coolant and inlet and outlet means (22) for said fluid.

4. Electronic power device according to Claim 3, **characterized in that** said two frames (1) are identical.

5. Electronic power device according to any one of Claims 1 to 4, **characterized in that** each support plate (3) is supplied with current by at least one emitter (12) and one collector (13) respectively extending beyond the two opposite edges of the support plate (3) so that the emitter (12) powering a support plate (3) is arranged on the same edge and in proximity to the collector (13) powering the support plate (3) arranged facing it.

6. Electronic power device according to Claims 3 and 5, **characterized in that** said frames (1) support said emitters (12), said collectors (13) and a control circuit (4) for the power components (31).

7. Electronic power device according to any one of Claims 5 or 6, **characterized in that** said support plates (3) each receive two IGBT components (31) having a common emitter (12) arranged between the two IGBT components (31) and extending outward laterally on one side of the frame (1), said IGBT components (31) each comprising an independent collector (13) extending outward laterally on the other side of the frame (1).

8. Electronic power device according to any one of Claims 1 to 7, **characterized in that** a strip (5) of heat-conducting material, such as copper or aluminium, is brazed or soldered onto the face of the support plates (3) in contact with the coolant, said strip (5) comprising folds forming microchannels favouring heat exchange with said fluid.

9. Electronic power device according to any one of Claims 1 to 8, **characterized in that** said frames (1) and modules (2) are produced by moulding using plastic material and are joined to one another by gluing or using a sealing gasket.

10. Electronic power device according to any one of Claims 1 to 9, **characterized in that** said support plates (3) are produced by joining an electrically-insulating but heat-conducting material, such as aluminium nitride, and a heat-conducting composite material that has an expansion coefficient matched to that of the electrically-insulating material, such as a composite of aluminium and silicon carbide, said electrically-insulating material supporting the power components and said composite being in contact with the coolant.

## Patentansprüche

1. Elektronische Leistungsvorrichtung, die Trägerplatten (3) aufweist, welche eine Seite, die ein oder mehrere Leistungsbauteile (31) aufnimmt, und eine entgegengesetzte Seite in Kontakt mit einem Wärmeträgerfluid zur Kühlung der Leistungsbauteile (31) durch Wärmeleitung aufweisen, **dadurch gekennzeichnet, dass** mindestens einer Trägerplatte (3) eine weitere Trägerplatte (3) zugeordnet ist, die ihr gegenüber angeordnet und mit gleichen Leistungsbauteilen (31) ausgestattet ist, und dass die Leistungsbauteile (31) der zwei einander gegenüber angeordneten Trägerplatten (3) einander gegenüber und in direkter Nähe zueinander angeordnet sind.

2. Elektronische Leistungsvorrichtung nach Anspruch 1, **dadurch gekennzeichnet, dass** jeder Trägerplatte (3) eine andere Trägerplatte (3) zugeordnet ist, die ihr gegenüber angeordnet und mit gleichen Leistungsbauteilen (31) ausgestattet ist, wobei die Leistungsbauteile (31) der einander gegenüber angeordneten Trägerplatten (3) einander gegenüber und in direkter Nähe zueinander angeordnet sind.

3. Elektronische Leistungsvorrichtung nach einem der Ansprüche 1 bis 2, **dadurch gekennzeichnet, dass** die Trägerplatten (3) auf zwei Rahmen (1) verteilt sind, die aus elektrisch isolierendem Material hergestellt sind, wobei jeder der Rahmen (1) Öffnungen (11) aufweist, deren Umriss einen Aufnahmesitz für die Trägerplatten (3) bildet, wobei die zwei Rahmen (1) eine Form haben, die die Zusammenfügung der zwei Rahmen (1) gegeneinander mit den Trägerplatten (3) der zwei Rahmen (1) einander gegenüber erlaubt, wobei die zwei aneinandergefügten Rahmen (1) auf ihrer freien Seite ein Kühlgehäuse (2) tragen, das einen Raum für den Kreislauf des Wärmeträgerfluids und Einrichtungen (22) für die Zufuhr und die Abfuhr des Fluids aufweist.

4. Elektronische Leistungsvorrichtung nach Anspruch 3, **dadurch gekennzeichnet, dass** die zwei Rahmen (1) gleich sind.

5. Elektronische Leistungsvorrichtung nach einem der Ansprüche 1 bis 4, **dadurch gekennzeichnet, dass** jede Trägerplatte (3) von mindestens einem Emitter (12) und einem Kollektor (13) mit Strom versorgt werden, die auf zwei entgegengesetzten Rändern der Trägerplatte (3) so überstehen, dass der eine Trägerplatte (3) speisende Emitter (12) auf der gleichen Seite wie der und in der Nähe des Kollektors (13) angeordnet ist, der die gegenüber angeordnete Trägerplatte (3) speist.

6. Elektronische Leistungsvorrichtung nach den Ansprüchen 3 und 5, **dadurch gekennzeichnet, dass** die Rahmen (1) die Emitter (12), die Kollektoren (13) und eine Steuerschaltung (4) der Leistungsbauteile (31) tragen.

7. Elektronische Leistungsvorrichtung nach einem der Ansprüche 5 bis 6, **dadurch gekennzeichnet, dass** die Trägerplatten (3) je zwei IGBT-Bauteile (31) aufnehmen, die einen gemeinsamen Emitter (12) aufweisen, der zwischen den zwei IGBT-Bauteilen (31) angeordnet ist und seitlich auf einer Seite des Rahmens (1) austritt, wobei die IGBT-Bauteile (31) je einen unabhängigen Kollektor (13) aufweisen, der seitlich auf der anderen Seite des Rahmens (1) austritt.

8. Elektronische Leistungsvorrichtung nach einem der Ansprüche 1 bis 7, **dadurch gekennzeichnet, dass** ein Band (5) aus wärmeleitendem Material wie Kupfer oder Aluminium auf die Seite der Trägerplatten (3) in Kontakt mit dem Wärmeträgerfluid gelötet oder geschweißt ist, wobei das Band (5) Falten aufweist, die Mikrokanäle bilden, welche den Wärmeaustausch mit dem Fluid begünstigen.

9. Elektronische Leistungsvorrichtung nach einem der Ansprüche 1 bis 8, **dadurch gekennzeichnet, dass** die Rahmen (1) und Gehäuse (2) durch Formen aus Kunststoff hergestellt und durch Kleben oder mit Hilfe einer Dichtung aufeinander montiert werden.

10. Elektronische Leistungsvorrichtung nach einem der Ansprüche 1 bis 9, **dadurch gekennzeichnet, dass** die Trägerplatten (3) durch den Zusammenbau eines elektrisch isolierenden aber wärmeleitenden Werkstoffs, wie Aluminiumnitrid, und eines wärmeleitenden Verbundwerkstoffs hergestellt werden, der einen Dehnungskoeffizient hat, der auf denjenigen des elektrisch isolierenden Werkstoffs abgestimmt ist, wie ein Verbundwerkstoff aus Aluminium und Siliciumcarbid, wobei der elektrisch isolierende Werkstoff die Leistungsbauteile trägt und der Verbundwerkstoff mit dem Wärmeträgerfluid in Kontakt steht.
